# EUROPÄISCHE PATENTSCHRIFT

(11) **EP 2 745 664 B1**
(45) Veröffentlichungstag und Bekanntmachung des Hinweises auf die Patenterteilung: **12.08.2015**
(21) Anmeldenummer: 12762196.9
(22) Anmeldetag: 20.06.2012
(51) Int. Cl.: H05K 7/20, H02B 1/56, F24F 13/065, F24F 13/075

(54) **BODENWANNE ZUM VERBINDEN EINES DACHAUFBAU-KÜHLGERÄTES MIT DEM DACH EINES SCHALTSCHRANKES**
FLOOR PAN FOR CONNECTING A ROOF-MOUNTED COOLING DEVICE TO THE ROOF OF A SWITCH CABINET
CHÂSSIS DE PROTECTION PERMETTANT DE RELIER UN CLIMATISEUR MONTÉ LE TOIT D'UNE ARMOIRE ÉLECTRIQUE AVEC LE TOIT DE LADITE ARMOIRE ÉLECTRIQUE

(30) Priorität: 16.08.2011 DE 202011050995 U
(43) Veröffentlichungstag der Anmeldung: 25.06.2014
(73) Patentinhaber: RITTAL GmbH & Co. KG, 35745 Herborn (DE)
(72) Erfinder: IMMEL, Manfred, 35756 Mittenaar 1 (DE)
(74) Vertreter: Angerhausen, Christoph
(86) Internationale Anmeldenummer: PCT/DE2012/000639
(87) Internationale Veröffentlichungsnummer: WO 2013/023633

(56) Entgegenhaltungen:
- EP-A1- 1 367 877
- DE-A1- 10 205 652
- DE-C1- 19 745 933
- DE-U1-202008 000 059

## Beschreibung

Die Erfindung betrifft eine Bodenwanne zum Verbinden eines Dachaufbau-Kühlgerätes mit dem Dach eines Schaltschrankes zur Kopplung eines Innenraumes des Schaltschrankes mit dem Innenkreis des Kältemittelkreislaufes des Dachaufbau-Kühlgerätes, mit mindestens einer Lufteintrittsöffnung zur fluchtenden Verbindung mit dem Warmluftausgang des Innenraums eines Schaltschrankes und mindestens einer Luftaustrittsöffnung zur Kommunikation mit dem/den Kaltlufteingang/eingängen des Innenraums des Schaltschranks, wobei die Lufteintrittöffnung(en) und die Luftaustrittsöffnung(en) im Boden der Bodenwanne vorgesehen sind und mit Lüftungsgittern oder Lüftungslamellen abgedeckt sind, und wobei mehrere Luftaustrittsöffnungen die mindestens eine Lufteintrittsöffnung umgebend angeordnet sind. Eine derartige Bodenwanne ist aus der DE 102 05 652 A1 bekannt.

Eine ähnliche Bodenwanne ist auch aus der DE 102 05 646 A1 bekannt. Diese Bodenwanne hat sich bewährt, um eine einfache variable Luftführung zwischen dem Schaltschrank und dem Kühlgerät zu schaffen und dabei bei einfachem konstruktiven Aufbau gleichzeitig die Entkopplung des Innenkreises vom Außenkreis des Kältemittelkreislaufes zu erleichtern und zu bewirken. Die Bodenwanne lässt sich leicht auf die Luftführung zwischen dem Schaltschrank-Innenraum und dem Dachaufbau-Kühlgerät anpassen und bildet gleichzeitig den Aufnahmeraum für die Komponenten des Innenkreises, wenn das vollständige Kühlgerät mit der Bodenwanne verbunden wird und dabei diese verschließt. Der Innenkreis mit seinen Komponenten ist damit in die Bodenwanne verlagert, mit dem Innenraum des Schaltschrankes gekoppelt und von dem Außenkreis des Kältemittelkreislaufes entkoppelt.

Die DE 20 2008 000 059 U1 und die DE 197 459 33 C1 beschreiben eine Luftdüse zur Leitung von aus einem Luftzuführungsschacht austretender Kühlluft mittels verschwenk- und verdrehbarer Lüftungslamellen zur Anwendung an Luftauslässen von Klimatisierungseinrichtungen in Fahrzeugen. Die EP 1 367 877 A1 beschreibt ein Dachaufbau-Kühlgerät.

Es kann jedoch der Zustand auftreten, dass sich die thermischen Bedingungen im Innenraum des Schaltschrankes ändern oder dass ein bereits vorhandener Schaltschrank besser als bisher klimatisiert werden soll.

Daher ist es die Aufgabe der Erfindung, die bekannte Bodenplatte dahingehend zu verbessern, dass die Kaltluftströme auch nachträglich an die tatsächlich herrschenden Temperaturverhältnisse im Schaltschrank angepasst werden können.

Diese Aufgabe wird durch eine Bodenwanne nach Anspruch 1 gelöst. Vorteilhafte Ausgestaltungen sind Gegenstand der Unteransprüche.

Erfindungsgemäß ist vorgesehen, dass zumindest ein Teil der Luftaustrittsöffnungen mit Lüftungslamellen abgedeckt ist, welche um eine in der Ebene des Bodens verlaufende Achse verschwenkbar und um eine senkrecht zu der Ebene des Bodens verlaufende Achse verdrehbar sind. Mit dieser Anordnung wird eine totraumoptimierte Führung der Kaltluftströme möglich. Durch Drehen der Lüftungslamellen kann die Richtung des Kaltluftstromes wie gewünscht gewählt werden, durch Verschwenken ist die Kaltluftmenge anzupassen.

Dabei ist nach einer bevorzugten Ausführungsform bei einer Bodenwanne mit einem im Wesentlichen rechtwinkligen Boden vorgesehen, dass eine mittig angeordnete Lufteintrittsöffnung von vier jeweils im Bereich einer Ecke des Bodens gelegenen Luftaustrittsöffnungen umgeben ist.

Vorzugsweise sind die Lüftungslamellen einer Luftaustrittsöffnung unabhängig von denen anderer Luftaustrittsöffnungen manuell oder motorisch betrieben zu verschwenken und/oder zu verdrehen. So kann beispielsweise in thermisch besonders belastete Bereiche gezielt eine große Kaltluftmenge geleitet werden, während andere Bereiche nur wenig oder gar nicht angeströmt werden.

Besonders bevorzugt sind die Lüftungslamellen in einem Einsatz oder einem Aufsatz für die Luftaustrittsöffnungen angeordnet und können so beispielsweise auf bestehende Stutzen einfach aufgesteckt werden. Damit ist ein Nachrüsten oder ein Austausch in einfachster Weise möglich.

Nach einer Ausgestaltung sind die Lüftungslamellen für jeweils eine Luftaustrittsöffnung über ein Hebelwerk gekoppelt.

Dabei kann vorgesehen sein, dass die Lüftungslamellen für jeweils eine Austrittsöffnung zwischen einer ersten Position, in der die Luftaustrittsöffnung vollständig verschlossen ist, und einer zweiten Position, in der die Luftaustrittöffnung maximal geöffnet ist, verschwenkbar sind. Jedwede Zwischenposition kann dabei eingenommen und gehalten werden.

Schließlich kann auch vorgesehen sein, dass die Lüftungslamellen für jeweils eine Luftaustrittsöffnung stufenlos oder im Raster drehbar sind.

Im Folgenden soll die Erfindung lediglich beispielhaft anhand der beigefügten Zeichnung näher erläutert werden. Dabei sollen die Darstellungen den grundlegenden Gedanken der Erfindung veranschaulichen und sind nicht notwendig maßstabsgetreu. Es zeigt:
- Figur 1: eine Ausführungsform eines Aufsatzes für eine Luftaustrittsöffnung einer Bodenwanne gemäß der vorliegenden Erfindung in perspektivischer Ansicht von der Kühlgeräteseite her gesehen;
- Figur 2: eine Schnittansicht des Aufsatzes der Figur 1 mit den Lüftungslamellen in einer Offen-Stellung;
- Figur 3: eine Schnittansicht ähnlich der Figur 2, jedoch mit den Lüftungslamellen in der Geschlossen-Stellung;
- Figur 4: eine Ansicht eines Aufsatzes für eine Lufteintrittsöffnung, im eingebauten Zustand von der Seite des Innenraums des Schaltschrankes her gesehen; und
- Figur 5: eine Draufsicht auf den Boden einer Bodenwanne nach einer Ausführungsform der vorliegenden Erfindung von der Seite des Innenraumes des Schaltschrankes her.

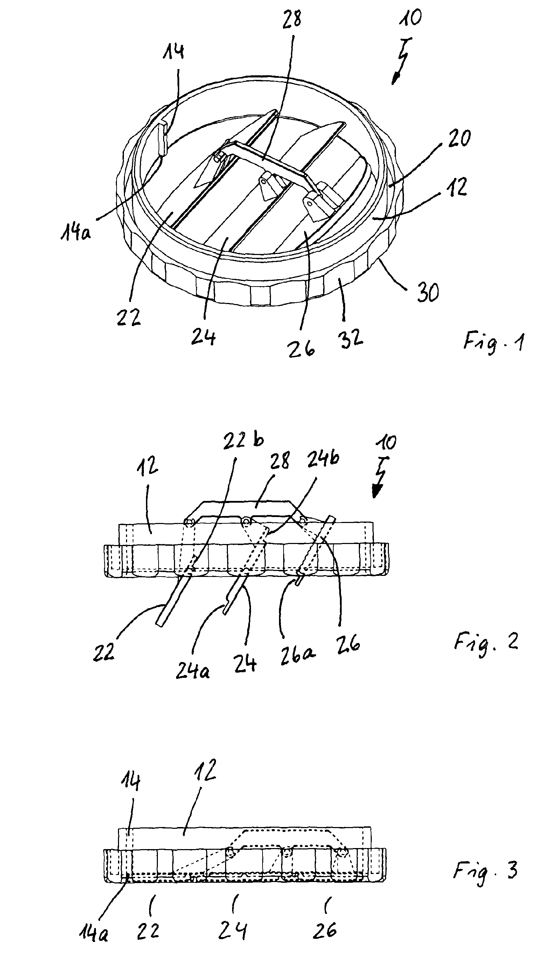

Nach einer bevorzugten Ausführungsform der vorliegenden Erfindung wird eine Bodenwanne zum Verbinden eines Dachaufbau-Kühlgerätes mit dem Dach eines Schaltschrankes zur Kopplung eines Innenraumes des Schaltschrankes mit dem Innenkreis des Kältemittelkreislaufes des Dachaufbau-Kühlgerätes mit Aufsätzen 10 für Luftaustrittsöffnungen versehen, wie sie in verschiedenen Darstellungen in den Figuren 1 bis 3 gezeigt sind. Diese Aufsätze 10 werden auf vorhandene Stutzen aufgesteckt und können somit leicht ausgetauscht oder nachgerüstet werden.

Figur 1 zeigt eine perspektivische Ansicht eines Aufsatzes 10, wie er im Wesentlichen im eingebauten Zustand von der Seite des Dachaufbau-Kühlgerätes her gesehen wird. In einem hohlzylindrischen Körper 12, dessen Außenradius im Wesentlichen dem Innenradius eines mit dem Aufsatz 10 auszustattenden Stutzens entspricht, sind drei Lüftungslamellen 22, 24, 26 angeordnet, die an einem Hebel 28 angelenkt sind, so dass sie gemeinsam um eine Achse verschwenkt werden können, die im eingebauten Zustand in der Ebene des Bodens der Bodenwanne oder parallel dazu liegt. In der Innenfläche des hohlzylindrischen Körpers 12 ist eine in axialer Richtung verlaufende Rippe 14 vorgesehen, welche die Schwenkbewegung der Lüftungslamellen 22, 24, 26 begrenzt. Dazu ist an der Rippe 14 eine untere Anschlagfläche 14a ausgebildet, an der in der Geschlossen-Stellung eine der Lüftungslamellen, nämlich die Lüftungslamelle 22 zur Anlage kommt. Der hohlzylindrische Körper 12 ist koaxial von einem Ringkörper 30 umgeben und mit diesem drehfest verbunden, so dass sich zwischen dem hohlzylindrischen Körper 12 und dem Ringkörper 30 eine umlaufende Nut 20 bildet, deren Breite in etwa der Wanddicke des Stutzens entspricht, auf dem der Aufsatz 10 aufgesteckt werden soll. Insgesamt sind die Abmessungen des hohlzylindrischen Körpers 12 und des Ringkörpers 30 in radialer und in axialer Richtung so abgestimmt, dass der Aufsatz 10 auf dem Stutzen kraftschlüssig gehalten wird und es keines Werkzeugs oder zusätzlicher Befestigungselemente für die Montage bedarf.

Der Ringkörper 30 ist an seiner Außenseite mit einer Vielzahl von Mulden 32 versehen, die als Griffhilfe für das Aufstecken des Aufsatzes 10 sowie das Verdrehen des Aufsatzes 10, soweit erforderlich, dienen. Die Winkelstellung der Lüftungslamellen 22, 24, 26 kann leicht vom Innenraum des Schaltschrankes her durch Drücken auf den Randbereich einer oder mehrerer Lüftungslamellen 22, 24, 26 geändert werden.

Obwohl das Verdrehen und das Verschwenken der Lamellen bei der dargestellten Ausführungsform manuell erfolgt, kann ebenso ein motorischer oder anderer Antrieb vorgesehen sein, der diese Bewegungen, ggf. auch unter Steuerung, beispielsweise abhängig von herrschenden Temperaturen und/oder Drücken erfolgen kann.

Außerdem ist der bisher beschriebene Aufsatz 10 für eine kontinuierliche Drehung gedacht. Es kann ebenso vorgesehen sein, den Aufsatz 10 so zu gestalten, dass eine Drehbewegung gerastert vorgenommen werden kann.

Figur 2 zeigt eine Schnittansicht des Aufsatzes 10 der Figur 1, wobei die Lüftungslamellen 22, 24, 26 in einer Offen-Stellung sind. Die Lamelle 22 weist an ihrem am Hebel 28 angelenkten Ende eine Stufe 22b auf, die in ihren Abmessungen in etwa einer Stufe 24a entspricht, die am freien Ende der Lamelle 24 vorgesehen ist. Die Lamelle 24 weist weiterhin an ihrem am Hebel 28 angelenkten Ende eine Stufe 24b auf, die in etwa komplementär zu einer Stufe 26a am freien Ende der Lamelle 26 ausgebildet ist. Durch manuelles Bewegen der Lamelle 22 an ihrem freien Ende werden auch die Lamellen 24, 26 durch Übertragen der Bewegung durch den Hebel 28 entsprechend bewegt, so dass die freie Durchtrittsfläche des hohlzylindrischen Körpers 12 je nach Erfordernis maximiert oder reduziert werden kann, und zwar bis in eine Geschlossen-Stellung, die in der Schnittdarstellung der Figur 3 gezeigt ist. In der Geschlossen-Stellung liegt das freie Ende der Lüftungslamelle 22 an der Anschlagfläche 14a der Rippe 14, die Stufen 22b und 24a sowie die Stufen 24b und 26a der entsprechenden Lamellen liegen aneinander, so dass der hohlzylindrische Körper 12 geschlossen ist und keine Luft durchtreten kann.

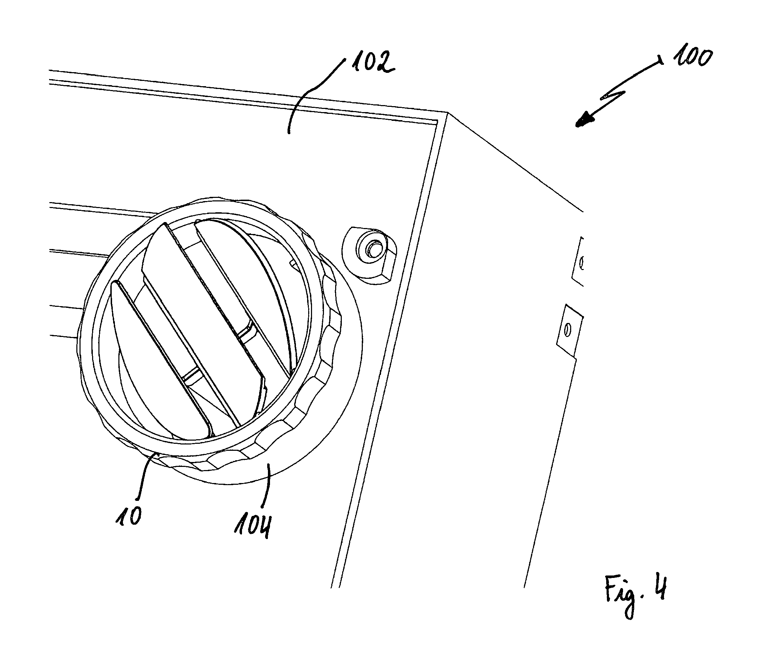

Figur 4 zeigt eine Ansicht eines Aufsatzes 10 für eine Lufteintrittsöffnung in einem Boden 102 einer Bodenwanne 100, wobei der Aufsatz 10 auf einen Stutzen 104 gesteckt ist, der die Lufteintrittsöffnung umgibt. Der Aufsatz 10 kann jetzt auf dem Stutzen 104 gedreht werden, bis die bei einer Offen-Stellung gewünschte Strömungsrichtung der Kaltluft erzielt wird. Da der Aufsatz 10 auch nachträglich noch verdreht werden kann, ist eine schnelle Anpassung an sich ändernde Temperaturverhältnisse innerhalb des Schaltschrankes möglich.

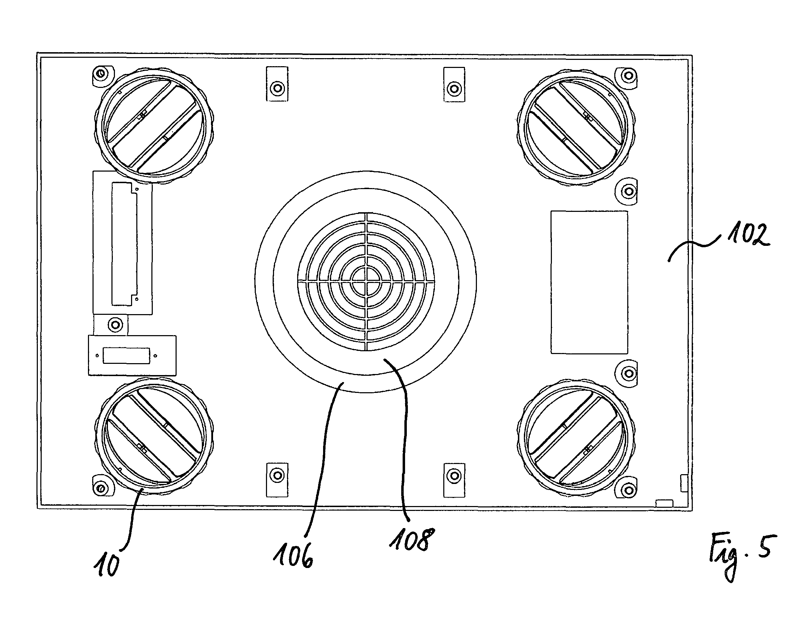

Figur 5 zeigt eine bevorzugte Anordnung, bei der im rechteckigen Boden 102 einer Bodenwanne mittig eine Lufteintrittsöffnung 106 für Warmluft angeordnet ist, die mit einem Lüftungsgitter 108 abgedeckt ist. In den Eckbereichen des Bodens 102 ist jeweils eine Luftaustrittsöffnung vorgesehen, die mit einem Aufsatz 10, wie im Zusammenhang mit der Figur 4 beschrieben, versehen ist. Alle Aufsätze 10 sind unabhängig voneinander verdrehbar, ihre Lüftungslamellen jeweils wie gewünscht verschwenkbar, so dass im Innenraum des Schaltschrankes angepasste und optimierte Luftströme, insbesondere Kaltluftströme, erzeugt werden können, die auch nachträglich noch zu ändern sind.

Die in der vorstehenden Beschreibung, in der Zeichnung sowie in den Ansprüchen offenbarten Merkmale der Erfindung können sowohl einzeln als auch in beliebiger Kombination für die Verwirklichung der Erfindung wesentlich sein.

## Patentansprüche

1. Bodenwanne (100) zum Verbinden eines Dachaufbau-Kühlgerätes mit dem Dach eines Schaltschrankes zur Kopplung eines Innenraumes des Schaltschrankes mit dem Innenkreis des Kältemittelkreislaufes des Dachaufbau-Kühlgerätes, mit
- mindestens einer Lufteintrittsöffnung (106) zur fluchtenden Verbindung mit dem Warmluftausgang des Innenraums eines Schaltschrankes, und
- mindestens einer Luftaustrittsöffnung zur Kommunikation mit dem/den Kaltlufteingang/eingängen des Innenraums des Schaltschranks,
wobei die Lufteintrittsöffnung(en) und die Luftaustrittsöffnung(en) im Boden (102) der Bodenwanne (100) vorgesehen sind und mit Lüftungsgittern (108) oder Lüftungslamellen (22, 24, 26) abgedeckt sind, und wobei mehrere Luftaustrittsöffnungen die mindestens eine Lufteintrittsöffnung (106) umgebend angeordnet sind,
**dadurch gekennzeichnet, dass** zumindest ein Teil der Luftaustrittsöffnungen mit Lüftungslamellen (22, 24, 26) abgedeckt ist, welche um eine in der Ebene des Bodens (102) verlaufende Achse verschwenkbar und um eine senkrecht zu der Ebene des Bodens (102) verlaufende Achse verdrehbar sind.

2. Bodenwanne nach Anspruch 1, mit einem rechtwinkligen Boden (102), **dadurch gekennzeichnet, dass** eine mittig angeordnete Lufteintrittsöffnung (106) von vier jeweils im Bereich einer Ecke des Bodens gelegenen Luftaustrittsöffnungen umgeben ist.

3. Bodenwanne nach Anspruch 1, **dadurch gekennzeichnet, dass** die Lüftungslamellen (22, 24, 26) einer Luftaustrittsöffnung unabhängig von denen anderer Luftaustrittsöffnungen manuell oder motorisch betrieben zu verschwenken und/oder zu verdrehen sind.

4. Bodenwanne nach Anspruch 1, **dadurch gekennzeichnet, dass** die Lüftungslamellen (22, 24, 26) in einem Einsatz oder einem Aufsatz (10) für die Luftaustrittsöffnungen angeordnet sind.

5. Bodenwanne nach Anspruch 1, **dadurch gekennzeichnet, dass** die Lüftungslamellen (22, 24, 26) für jeweils eine Luftaustrittsöffnung über ein Hebelwerk (28) gekoppelt sind.

6. Bodenwanne nach Anspruch 1, **dadurch gekennzeichnet, dass** die Lüftungslamellen (22, 24, 26) für jeweils eine Luftaustrittsöffnung zwischen einer ersten Position, in der die Luftaustrittsöffnung vollständig verschlossen ist, und einer zweiten Position, in der die Luftaustrittsöffnung maximal geöffnet ist, verschwenkbar sind.

7. Bodenwanne nach Anspruch 1, **dadurch gekennzeichnet, dass** die Lüftungslamellen (22, 24, 26) für jeweils eine Luftaustrittsöffnung stufenlos oder im Raster drehbar sind.

## Claims

1. A floor pan (100) for connecting a roof-mounted cooling device to the roof of a switchgear cabinet for coupling an interior of the switchgear cabinet to the inner circuit of the refrigerant circulation of the roof-mounted cooling device, having
- at least one air inlet opening (106) aligned with the hot air outlet of the inner chamber of the switchgear cabinet, and
- at least one air outlet opening communicating with the cold air inlet(s) of the inner chamber of the switchgear cabinet,
wherein the air inlet opening(s) and the air outlet opening(s) are provided in the base (102) of the floor pan (100) and are covered by ventilation grilles (108) or ventilation louvres (22, 24, 26), and wherein a plurality of air outlet openings are arranged surrounding the at least one air inlet opening (106),
**characterized in that** and at least part of the air outlet openings are covered by ventilation louvres (22, 24, 26) that are pivotable about an axis running in the plane of the base (102) and are rotatable about an axis running perpendicular to the plane of the base (102).

2. The floor pan of claim 1, having a rectangular floor (102), **characterized in that** a centered air inlet opening (106) is surrounded by four air outlet openings which are respectively arranged in a corner region of the base.

3. The floor pan of claim 1, **characterized in that** the ventilation louvres (22, 24, 26) of any air outlet opening can be pivoted and/or rotated manually or driven by a motor independently from those of other air outlet openings.

4. The floor pan of claim 1, **characterized in that** the ventilation louvres (22, 24, 26) are disposed within an insert or a top part (10) for the air ventilation openings.

5. The floor pan of claim 1, **characterized in that** the ventilation louvres (22, 24, 26) for respectively one air outlet opening are coupled via a lever assembly.

6. The floor pan of claim 1, **characterized in that** the ventilation louvres (22, 24, 26) for respectively one air outlet opening are pivotable between a first position where the air outlet opening is completely closed, and a second position, where the air outlet opening is opened to the maximum.

7. The floor pan of claim 1, **characterized in that** the ventilation louvres (22, 24, 26) for respectively one air outlet opening are continuously rotatable or can be rotated in steps.

## Revendications

1. Cuve de base (100) permettant d'assembler un refroidisseur à montage sur toit avec le toit d'une armoire électrique, afin de coupler l'espace intérieur de l'armoire électrique avec le circuit intérieur du circuit de fluide frigorigène du refroidisseur à montage sur toit, comportant
- au moins une ouverture d'entrée d'air (106) pour un assemblage aligné avec la sortie d'air chaud de l'espace intérieur d'une armoire électrique, et
- au moins une ouverture de sortie d'air pour la communication avec l'entrée ou les entrées d'air froid de l'espace intérieur de l'armoire électrique,
le ou les ouverture(s) d'entrée d'air et le ou les ouverture(s) de sortie d'air étant prévues dans le fond (102) de la cuve de base (100) et étant protégées par des grilles d'aération (108) ou des lamelles d'aération (22, 24, 26), et plusieurs ouvertures de sortie d'air étant disposées en entourant au moins une ouverture d'entrée d'air (106),
**caractérisée en ce qu'**au moins une partie des ouvertures de sortie d'air sont protégées par des lamelles d'aération (22, 24, 26), qui sont aptes à pivoter autour d'un axe s'étendant dans le plan du fond (102) et sont aptes à tourner autour d'un axe s'étendant perpendiculairement au plan du fond (102).

2. Cuve de base selon la revendication 1, comportant un fond (102) rectangulaire, **caractérisée en ce qu'**une ouverture d'entrée d'air (106) disposée au centre est entourée par quatre ouvertures de sortie d'air disposées chacune dans la zone d'un coin du fond.

3. Cuve de base selon la revendication 1, **caractérisée en ce que** les lamelles d'aération (22, 24, 26) d'une ouverture de sortie d'air sont actionnées manuellement ou par moteur pour pivoter et/ou pour tourner indépendamment de celles d'autres ouvertures de sortie d'air.

4. Cuve de base selon la revendication 1, **caractérisée en ce que** les lamelles d'aération (22, 24, 26) sont disposées dans un insert ou une rehausse (10) pour les ouvertures de sortie d'air.

5. Cuve de base selon la revendication 1, **caractérisée en ce que** les lamelles d'aération (22, 24, 26) respectivement pour une ouverture de sortie d'air sont couplées par l'intermédiaire d'un mécanisme à levier (28).

6. Cuve de base selon la revendication 1, **caractérisée en ce que** les lamelles d'aération (22, 24, 26) respectivement pour une ouverture de sortie d'air sont aptes à pivoter entre une première position, dans laquelle l'ouverture de sortie d'air est complètement fermée, et une deuxième position, dans laquelle l'ouverture de sortie d'air est ouverte au maximum.

7. Cuve de base selon la revendication 1, **caractérisée en ce que** les lamelles d'aération (22, 24, 26) respectivement pour une ouverture de sortie d'air sont aptes à tourner en continu ou dans un cadre.
